(19) Europäisches Patentamt / European Patent Office / Office européen des brevets

(11) **EP 4 597 301 A1**

(12) **EUROPEAN PATENT APPLICATION**

(43) Date of publication:
**06.08.2025 Bulletin 2025/32**

(21) Application number: **24305182.8**

(22) Date of filing: **01.02.2024**

(51) International Patent Classification (IPC):
**G06F 7/544** (2006.01)   **G06F 17/10** (2006.01)

(52) Cooperative Patent Classification (CPC):
**G06F 7/544; G06F 17/10**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Secure-IC SAS**
**35510 Cesson-Sévigné (FR)**

(72) Inventor: **GUILLEY, Sylvain**
**75013 Paris (FR)**

(74) Representative: **Atout PI Laplace**
**Immeuble Up On**
**25 Boulevard Romain Rolland**
**CS 40072**
**75685 Paris Cedex 14 (FR)**

(54) **A PROCESSING SYSTEM AND METHOD FOR FAST EVALUATION OF A BOOLEAN FUNCTION**

(57)    There is provided a processing system (1) configured to execute one or more processing operations, the execution of said one or more processing operations involving the evaluation of at least one Boolean function. The processing system comprises an evaluation device (20) configured to evaluate each Boolean function $f$ defined from $\mathbb{F}_2^n$ over $\mathbb{F}_2$, in a variable $x$ of length $n$ over $\mathbb{F}_2^n$. The evaluation device (20) comprises:
- a differential calculation unit (203) configured to calculate differentials $\Delta f(y) = f(y) \oplus f(y - 1)$ for each integer intermediary variable $y$ ranging from 1 to $2^n$ - 1;
- An accumulation unit (201) configured to sum, using the XOR operator, the product of the differential $\Delta f(y)$ and $c_n^{2^n-y}(x)$ for each value of $y$ ranging from 1 to $2^n$ - 1, according to the following XOR accumulation term $\bigoplus_{y=1}^{2^n-1} (\Delta f(y)) c_n^{2^n-y}(x)$, where $c_n^z(x)$ is the function associating $x$ to the outbound carry of arithmetic summation $x + z$ ;
- A XOR adder (204) configured to add $f(0)$ to the result of the accumulation unit (201),
wherein the output of the XOR adder provides the result of the evaluation of the Boolean function $f$.

```
┌─────────────────────────────────────────────┐
│ Pre-calculating the differentials Δf(y) for   │ ── 300
│ each y ranging form 1 to 2^{n-1}              │
└─────────────────────────────────────────────┘
                      │
                      ▼
┌─────────────────────────────────────────────┐
│ Initializing the accumulator a to f(0)        │ ── 302
└─────────────────────────────────────────────┘
                      │
                      ▼
┌─────────────────────────────────────────────┐
│ Accumulating Δf(y) and the carry c_n^{2^n-y}(x)│ ── 304
│ in the accumator a for each value of y         │
│ through XOR                                    │
└─────────────────────────────────────────────┘
                      │
                      ▼
┌─────────────────────────────────────────────┐
│ Returning a                                    │ ── 306
└─────────────────────────────────────────────┘
```

**FIGURE 3**

EP 4 597 301 A1

**Description**

The invention generally relates to processing systems and, in particular, to a processing system configured to execute a processing operation involving at least one Boolean function.

**BACKGROUND**

Many processing systems are based on the execution of one or more processing operations involving Boolean functions. Boolean functions are in particular pervasive in computing systems and in cryptographic systems.

However, the execution of Boolean functions involves complex evaluations that impact the performances and the computational complexity of the processing system.

Existing processing systems can evaluate Boolean functions using two kinds of techniques:

- a first technique is a 'Tabulation' technique. It consists in looking up in a potentially large function truth table;

- a second technique is a transformation technique in some standard representation, such as Algebraic Normal Form (ANF), the Conjunctive Normal Form (CNF), or the Disjunctive Normal Form (DNF), which, while systematic, involves unnatural and complex basis vector evaluations.

While the tabulation is memory intensive, the transformation technique such as ANF/CNF/DNF requires evaluation in some vector basis, which is computationally intensive. In particular, ANF requires the evaluation of monomial functions, CNF requires the evaluation of maxterms, and DNF requires the evaluation of minterms.

There is consequently a need for improved systems, methods, and computer program products capable of performing a fast evaluation of Boolean functions and thereby improve the performances of the processing system.

**SUMMARY**

To address these and other problems, there is provided a processing system configured to execute one or more processing operations, the execution of said one or more processing operations involving the evaluation of at least one Boolean function. The processing system comprises an evaluation device configured to evaluate each Boolean function f defined from the n-dimensional vector space $\mathbb{F}_2^n$ over the prime field vector space $\mathbb{F}_2$, in a variable $x$, $x$ being a vector of length $n$ over the vector space $\mathbb{F}_2^n$. The evaluation device comprises:

- a differential calculation unit configured to calculate differentials $\Delta f(y) = f(y) \oplus f(y - 1)$ for each integer intermediary variable y ranging from 1 to $2^n - 1$;

- An accumulation unit configured to sum, using the XOR operator, the product of the differential $\Delta f(y)$ and $c_n^{2^n - y}(x)$ for each value of y ranging from 1 to $2^n - 1$, according to the following XOR accumulation term:

$$\oplus_{y=1}^{2^n - 1}\left(\Delta f(y)\right)c_n^{2^n - y}(x),$$

where $c_n^z(x)$ is the function associating $x$ to the outbound carry of arithmetic summation $x + z$,

- A XOR adder configured to add $f(0)$ to the result of the accumulation unit,

the output of the XOR adder providing the result of the evaluation of the Boolean function f.

In some aspects, the evaluation device may be implemented in the form of a hardware circuit, the evaluation device comprising a sequential value generator configured to generate sequential values of the intermediary variable $y$ from 1 to $2^n - 1$.

The evaluation device may comprise a carry generator configured to determine the arithmetic carry $c_n^{2^n - y}(x)$ that is conditioned, using an AND gate, to the fact that the differential $\Delta f(y)$ is true, for each value of the intermediary variable $y$, the input $x$ being submitted to the carry generator, and the output of the evaluation device being provided after $2^n - 1$ clock cycles in the accumulation unit.

In some embodiments, the accumulation unit may comprise two multiplexors and a DFF memory, the DFF memory receiving as inputs the output of the second multiplexor and a system clock signal.

The sequential value generator may be implemented as a counter and comprises an adder, without a carry, followed by a DFF memory that receives, as inputs, the output of the adder and a system clock signal, the DFF memory returning the current value of the intermediary variable, the adder receiving back as input the output of the DFF memory and the value 1.

In some embodiments, the carry generator may comprise an adder, with a carry, followed by an AND component receiving, as inputs, the output of the adder and the differential value for the current value of the intermediary variable $y$, the adder receiving, as inputs, the input $x$ and an input $2^n - y$, and providing an output comprising on n bits $x - y \bmod 2^n$ and on 1 bit a carry flag corresponding to the carry $c_n^{2^n-y}(x)$, the AND component being configured to perform a AND operation between the differential value $\Delta f(y)$ and the carry $c_n^{2^n-y}(x)$.

In some embodiments, the evaluation device may be configured to evaluate the Boolean function $f$ in $K$ input values $x_k$ with $1 \le k \le K$, using a parallel Single-Instruction-Multiple-Data implementation parallelized only on the values $x_k$.

In some embodiments, the evaluation device may be configured to evaluate in parallel $K$ Boolean functions $f_k$ in $K$ input values $x_k$ with $1 \le k \le K$, using a Single-Instruction-Multiple-Data architecture parallelized on the values $x_k$.

In some embodiments, the evaluation device may be configured to evaluate a Boolean function $f$ in $x$, when the differential $\Delta f$ of the function $f$ is sparse, using a look-up-table (LUT) $V_f$

The evaluation device may be configured to determine the look-up table from a truth table associated with the Boolean function.

In one embodiment, the processing system may be a cryptographic system, and a processing operation may be a cryptographic operation.

In some aspects, the carry may be defined from intermediate bits of the addition of $x$ and $y$.

There is further provided a processing method for executing one or more processing operations, the execution of said one or more processing operations involving the evaluation of at least one Boolean function. The processing method comprises a step of evaluating each Boolean function $f$ defined from the n-dimensional vector space $\mathbb{F}_2^n$ over the prime field vector space $\mathbb{F}_2$, in a variable $x$, $x$ being a vector of length $n$ over the vector space $\mathbb{F}_2^n$, wherein the evaluation step comprises:

- calculating differentials $\Delta f(y) = f(y) \oplus f(y - 1)$ for each integer intermediary variable y ranging from 1 to $2^n - 1$;

- summing, using the XOR operator, the product of the differential $\Delta f(y)$ and $c_n^{2^n-y}(x)$ for each value of y ranging from 1 to $2^n - 1$, according to the following XOR accumulation term:

$$\oplus_{y=1}^{2^n-1}\left(\Delta f(y)\right)c_n^{2^n-y}(x),$$

where $c_n^z(x)$ is the function associating $x$ to the outbound carry of arithmetic summation $x + z$ ;
- adding $f(0)$ to the result of the summing step, which provides the result of the evaluation of the Boolean function f.

**BRIEF DESCRIPTION OF THE DRAWINGS**

The accompanying drawings, which are incorporated in and constitute a part of this specification, illustrate various embodiments of the invention and, together with the general description of the invention given above, and the detailed description of the embodiments given below, serve to explain the embodiments of the invention.

- Figure 1 depicts a processing system, in accordance with embodiments of the invention.

- Figure 2 depicts the structure of the Boolean function evaluation device, according to some embodiments.

- Figure 3 is a flowchart depicting a method of evaluating a Boolean function f, according to some embodiments.
- Figure 4 depicts a hardware implementation of accumulation unit, according to a first embodiment.
- Figure 5 depicts a hardware implementation of the sequential value generator, according to the first embodiment.
- Figure 6 depicts a hardware implementation of the carry generator, according to the first embodiment.
- Figure 7 depicts a SIMD hardware implementation of accumulation unit, according to a second embodiment.

- Figure 8 depicts a SIMD hardware implementation of the sequential value generator, according to the second embodiment.
- Figure 9 depicts a SIMD hardware implementation of the carry generator, according to the second embodiment.
- Figure 10 depicts a SIMD hardware implementation of accumulation unit, according to a third embodiment where $K$ fast Boolean functions $f_k$ are evaluated in $K$ input values $x_k$.
- Figure 11 depicts a SIMD hardware implementation of the sequential value generator, according to the third embodiment.
- Figure 12 depicts a SIMD hardware implementation of the carry generator, according to the third embodiment.
- Figure 13 depicts a hardware implementation of accumulation unit, according to a fourth embodiment where $\Delta f$ is sparse, using a look-up table.
- Figure 14 depicts a hardware implementation of the sequential value generator, according to the fourth embodiment.
- Figure 15 depicts a hardware implementation of the carry generator, according the fourth embodiment.
- Figure 16 is a flowchart depicting the determination of the look-up-table of the Boolean function $f$, according the fourth embodiment.
- Figure 17 illustrates an exemplary computation of the look-up-table of a Boolean function $f$.

## DETAILED DESCRIPTION

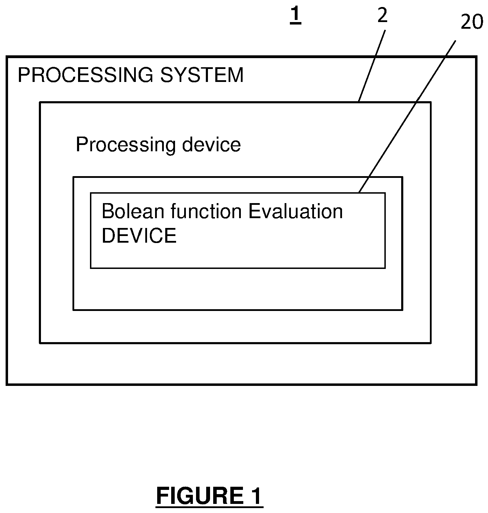

Referring to Figure 1, an operating environment in accordance with embodiments of the invention is shown. The operating environment includes a processing system 1 according to embodiments of the invention.

The processing system 1 is configured to execute at least one processing operation comprising one or more Boolean functions.

The processing operation may be for example a cryptographic function or a cryptographic algorithm.

The processing system 1 may be any processing system, device, chip or circuit executing the processing operation such as for example and without limitation a cryptographic system, a computing device (such as a compiler or a SAT solver), a digital processing system for real-time data filtering, etc.

The processing system 1 comprises a processing device 2 configured to execute the processing operation. The processing device may be configured to execute the processing operation by evaluating one or more elementary operations related to the processing operation, the elementary operation(s) comprising one or more Boolean functions.

The elementary operations may comprise other types of operations such as for example and without limitations, a basic arithmetic operation (addition, multiplication, etc.), a scaling operation (such as a multiplication with a constant), an exponentiation (such as a self-multiplication performed a given number of times), etc.

It should be noted that in some embodiments, a processing operation may be itself a Boolean function.

The processing device comprises a Boolean function evaluation device 20 (also called simply 'evaluation device') configured to perform fast evaluation of each Boolean function, according to the embodiments of the disclosure.

Advantageously, the Boolean function evaluation device 20 exploits a novel transform of any $n$-bit Boolean function $f$ evaluated in $x$, hereinafter called "Guilley Transform", which enables to limit the complexity of the evaluation and speed its evaluation. The Boolean function evaluation device 20 takes advantage of the computer system builtin arithmetic operation (addition) that yields a complex expression for a carry to speed-up evaluation of basis vectors. The evaluation device 20 according to the embodiments of the invention allows evaluating any $n$-bit Boolean function in average in $2^{n}-1$ carries evaluations.

To facilitate the understanding of some embodiments of the disclosure, the following notations will be used:

- $\mathbb{F}_2$ denotes the set of two elements $\mathbb{F}_2 = \{0, 1\}$.

- Considering $n > 1$ being a strictly positive integer, the Cartesian product $\mathbb{F}_2^n$ is an $\mathbb{F}_2$- vector space.

- $0_n$ denotes the all zero vector living in $\mathbb{F}_2^n$.

- $1_n$ denotes the all one vector living in $\mathbb{F}_2^n$.

- a vector is said to be equal to zero, if it is equal to $0_n$ in the case of clear context.

A Boolean function refers to a function whose arguments and result assume values from a two-element set (such as {true, false}, {0,1} or {-1,1}).

The set of all Boolean functions is endowed with a structure of $\mathbb{F}_2$ -vector space. Namely, $\mathcal{BF}_n$ *denotes* the $\mathbb{F}_2$ - vector space of all n-variable Boolean functions $f : \mathbb{F}_2^n \to \mathbb{F}_2$. The dimension of $\mathcal{BF}_n$ is $2^n$. The total number of Boolean functions is $2^{2^n}$.

The Boolean functions may include different types of Boolean functions such as :

- $a \vee b$ which denotes the OR between the bits $a$ and $b$.
- $a \wedge b$, or simply $ab$ when there is no notation ambiguity, which denotes the AND between the bits $a$ and $b$.
- $a \oplus b$ which denotes the exclusive OR (or XOR) of bits $a$ and $b$.

The same notations extend to vector of bits, component-wise.

Further to facilitate the understanding of the following description of some embodiments of the disclosure, the following definitions are given.

The canonical basis $(\delta_u)_{u \in \mathbb{F}_2^n}$ of $\mathcal{BF}_n$ is defined by Equation (1):

$$\delta_u(x) = \prod_{i=0}^{n-1}(x_i \oplus u_i) = \begin{cases} 1 \ if \ x = u \\ 0 \ otherwise \end{cases} \quad (1)$$

The monomial basis is further defined by Equation (2):

$$\phi_u(x) = \prod_{i|u_i=1} x_i = \prod_{i=0}^{n-1} x_i^{u_i} \quad (2)$$

In Equation (2), the power notation is such that $x_i^0 = 1$ and $x_i^1 = 1$.

The degree of the monomial $\phi_u(x) = \prod_{i=0}^{n-1} x_i^{u_i}$ refers to the number of coordinates involved in the product, that I s, the Hamming weight $w_H(u) = \sum_{i=0}^{n-1} u_i$ of u.

Further, the degree deg(f) of any Boolean function $f: \mathbb{F}_2^n \longrightarrow \mathbb{F}_2$ is the maximum value in the decomposition of the degrees of the monomials basis. A function of zero degree is simply a constant (0 or 1), while a function of unit degree is simply a linear combination of bit values.

The notation $\mathcal{BF}^0$ will be used to denote the vectorial space of Boolean functions which are equal to zero in zero. $\mathcal{BF}^0$ can be therefore defined as:

$$\mathcal{BF}^0 = \{ f \in \mathcal{BF}_n, such \ that \ f(0) = 0 \} \quad (3)$$
$$= span (\{\phi_u, u \neq 0\}) \quad (4)$$

The algebraic normal form (ANF) of a Boolean function $f$ designates its decomposition over the monomial basis. Namely, it is the unique representation of $f$ as:

$$f(x) = \bigoplus_{u \subset \{0,1\}^n} a_u \phi_u(x) \quad (5)$$

In formula (5), the coefficients $a_u \in \mathbb{F}_2$ define the Boolean function $f$.

By convention, the vector representation is such that the vectors are represented in the following order: $(11 \ldots 1)_2$, $(11 \ldots 0)_2, \ldots, (00 \ldots 0)_2$. Such vector order corresponds to the order compatible with the representation of Boolean vectors as integers.

The ANF can be computed using a Möbius transform, which consists in applying the following matrix $M_{2^n}$ to the vector $(f(11 \ldots 1), f(11 \ldots 0), \ldots, f(00 \ldots 0))$. The Möbius matrix $M_{2^i}$ can be defined recursively as:

$$M_{2^0} = (1) \text{ and } M_{2^{i+1}} = \begin{pmatrix} M_{2^i} & 0 \\ M_{2^i} & M_{2^i} \end{pmatrix} \quad (6)$$

Assuming that for $n = 2$, $f(x) = x_1 \vee x_0$, the ANF obtained by applying the matrix $M_{2^n}$ to the vector $(f(11 \ldots 1), f(11 \ldots 0), \ldots, f(00 \ldots 0))$ is defined by $(a_{11}, a_{10}, a_{01}, a_{00})$ such that :

$$(a_{11}, a_{10}, a_{01}, a_{00}) = (f(11), f(10), f(01), f(00))M_{2^n} = (1,1,1,0)\begin{pmatrix} 1\ 0\ 0\ 0 \\ 1\ 1\ 0\ 0 \\ 1\ 0\ 1\ 0 \\ 1\ 1\ 1\ 1 \end{pmatrix} \quad (7)$$

$$= (1,1,1,0) = x_1 x_0 \oplus x_1 \oplus x_0$$

There follows a definition of the addition in $\mathbb{Z}_{2^n}$ to which it will be referred to in connection with some embodiments of the disclosure. Considering x ∈ {0, 1}$^n$, x can be associated to the integer $\sum_{i=0}^{n-1} x_i \, 2^i$, which belongs to the interval {0,..., 2$^n$ - 1}. There is a bijection between n-dimensional vectors in $\mathbb{F}_2^n$ and integers in {0,..., 2$^n$ - 1}. $\mathbb{F}_2^n$ will be hereinafter associated with {0,.., 2$^n$ - 1}.

Given two integers $x, y \in$ {0,..., 2$^n$ - 1}, their arithmetic sum z = x + y belonging to 2 is defined in a vectorial form as:

$$z = (c_n, x_{n-1} \oplus y_{n-1} \oplus c_{n-1}, \ldots, x_0 \oplus y_0 \oplus c_0) \in \mathbb{F}_2^{n+1} \quad (8)$$

In Equation (8):

$$\begin{cases} c_0 = 0 \\ c_i = MAJ(x_{i-1}, y_{i-1}, c_{i-1}) \, for \, 1 \le i \le n \end{cases} \quad (9)$$

The *MAJ* ternary function is termed the "majority", and is expressed as:

$$MAJ(a, b, c) = ab \vee bc \vee ca = ab \vee (a \oplus b)c \quad (10)$$

The *MAJ* ternary function has the following properties:

$$MAJ(a, b, 0) = ab \quad (11)$$

$$MAJ(a, b, 1) = a \vee b = a \oplus b \oplus ab \quad (12)$$

The (n + 1)-th component of *z* (i.e. the component of index n, namely $c_n$), is called the "carry" of the addition of *x* and y, for $x, y \in$ {0, ..., 2$^{n-1}$}, represented as bit vectors x = ($x_{n-1}$ ,..., $x_0$) and Y = ($y_{n-1}$ ,..., $y_0$ ).

As used herein, a carry function of addition with y is denoted $c_y$, considering y belonging to $\mathbb{F}_2^n$ ( $y \in \mathbb{F}_2^n$ ). The carry function $c_n^y$ is defined from $\mathbb{F}_2^n$ to $\mathbb{F}_2$ as:

$$c_n^y \colon (x_{n-1}, \ldots, x_0) \mapsto c_n(x_{n-1}, \ldots, x_0) \quad (13)$$

In formula (13), $c_n$ is defined iteratively on index *n* by equation (9).

As defined herein, a carry is not limited to a summation. For example, in an extreme case, $\forall y \in$ {0,1}$^n$, defined such that (¬y) + y = (¬y) $\oplus$ y = (11 ... 1)$_2$ = 2$^n$ - 1, it yields a word only made up of 1s, but where no carry (even intermediate, at positions 0 ≤ i ≤ n - 1) do occur. It should be noted that subtractions of *x* and *d* can be expressed the sum of x and -y = 2$^n$ - y *mod* 2$^n$, where for all $y \in \mathbb{F}_2^n$, -y = ¬y + 1.

To arrive to the Guilley Transform, the inventors have established a first theorem according to which the family of carries of additions for x ∈ {0,..., 2$^{n-1}$} → x + y, for the 2$^{n-1}$ non-zero values y ∈ {0,..., 2$^{n-1}$} forms a basis of $\mathcal{BF}_n^0$. This first theorem also holds if y is chosen equal to 0$_n$, as in this case, $c_n$ is the constant zero function so that:

$$\forall x \in \mathbb{F}_2^n, c_n^0(x) = 0$$

This first theorem can be proved by induction on $n$. Indeed, for $n = 1$, the considered family of carries is made up of the single function $x = (x_0) \in \mathbb{F}_2^1 \mapsto x_0 + 1$, which is equal to $(x_0, x_0 \oplus 1) \in \mathbb{F}_2^2$. The carry is therefore $x = (x_0) \mapsto x_0$. As $BF_1 = span(x \mapsto 1, x \mapsto x)$, it comes $BF_1^0 = span(x \mapsto x)$.

Assuming that the first theorem is correct up to n, the family of functions that are considered is:

$$x = (x_n, x_{n-1}, \ldots, x_0) \in \mathbb{F}_2^{n+1} \to x + y$$

It can be noted that:

$$
\begin{aligned}
&\{c_{n+1}^y, y \in \mathbb{F}_2^{n+1}\} \\
&= \{c_{n+1}^y(0, y_{n-1}, \ldots, y_0) \in \mathbb{F}_2^{n+1}\} \cup \{c_{n+1}^y(1, y_{n-1}, \ldots, y_0) \in \mathbb{F}_2^{n+1}\} \\
&= \{x \mapsto x_n c^y(x_{n-1}, \ldots, x_0), y \in \mathbb{F}_2^n\} \cup \\
&\quad \{x \mapsto x_n c^y(x) \oplus x_n \oplus c^y(x), y \in \mathbb{F}_2^n\}.
\end{aligned}
$$

$$(14)$$

The last term $x \to x_n c^y(x) \oplus x_n \oplus c^y(x)$, $y \in \mathbb{F}_2^{n+1}$ of formula (14) uses the properties (11) and (12), hence:

$$span(\{c_{n+1}^y, y \in \mathbb{F}_2^{n+1}\}) = \{x \to x_n f(x), f \in BF_n^0\} \oplus \{x \to x_n \oplus f(x) \oplus x_n f(x), f \in BF_n^0\} \quad (15)$$

The first term $\{x \to x_n f(x), f \in BF_n^0\}$ of formula (15) contains all monomials that contain $x_n$ except $x_n$ alone, and the second term $\{x \to x_n \oplus f(x) \oplus x_n f(x), f \in BF_n^0\}$ of formula (15) contains $x_n$ alone (for $f = 0$, which belongs to the vector space $BF_n^0$), and vectors of the form $x_n \oplus f(x) \oplus x_n f(x)$, for $f \in BF_n^0$. Those vectors can be added (i.e., subtracted in $\mathbb{F}_2$) to $x_n$ and $x_n f(x)$ to get simply $f(x)$. Therefore all vectors $\phi_u$ of $(n + 1)$ variables, except 1, can be generated.

For example, in the case $n = 3$, the expression $x, y \to x + y$ can be expressed as:

$$x, y \to x + y = (z_3, z_2, z_1, z_0) = c_3, c_2 \oplus x_2 \oplus y_2, c_1 \oplus x_1 \oplus y_1, c_0 \oplus x_0 \oplus y_0) \quad (16)$$

In equation (16):

$$
\begin{cases}
c_0 = 0 \\
c_1 = x_0 y_0 \\
c_2 = x_0 y_1 y_0 \oplus x_1 y_0 \oplus x_1 x_0 y_0 \\
c_3 = x_0 y_2 y_1 y_0 \oplus x_1 y_2 y_1 \oplus x_2 y_2 \oplus x_1 x_0 y_2 y_0 \oplus x_2 x_1 y_1 \oplus x_2 x_0 y_1 y_0 \oplus x_2 x_1 x_0 y_0
\end{cases}
$$

The expression of $c_n^y$ can be deduced as :

| | | | | | | | | | | | | |
|---|---|---|---|---|---|---|---|---|---|---|---|---|
| $(111)_2$ : | $x_2$ | $\oplus$ | $x_1$ | $\oplus$ | $x_0$ | $\oplus$ | $x_1 x_0$ | $\oplus$ | $x_2 x_1$ | $\oplus$ | $x_2 x_0$ | $\oplus$ | $x_2 x_1 x_0$ |
| $(110)_2$ : | $x_2$ | $\oplus$ | $x_1$ | $\oplus$ | | | | | $x_2 x_1$ | | | | |
| $(101)_2$ : | $x_2$ | $\oplus$ | | | | | $x_1 x_0$ | $\oplus$ | | | | | $x_2 x_1 x_0$ |
| $(100)_2$ : | $x_2$ | | | | | | | | | | | | |
| $(011)_2$ : | | | | | | | | | $x_2 x_1$ | $\oplus$ | $x_2 x_0$ | $\oplus$ | $x_2 x_1 x_0$ |
| $(010)_2$ : | | | | | | | | | $x_2 x_1$ | | | | |
| $(001)_2$ : | | | | | | | | | | | | | $x_2 x_1 x_0$ |

(continued)

$(000)_2 :$      0

It can be noted that the order of the monomials shall not be chosen at random. They can be therefore ordered in the lexicographical example of $y \to x^I$, with $I \in \{0,1\}^n$.

In the case $n = 1$, $x$, $y$ -, $x + y = (x_1 y_1, x_0 y_0)$ so that :

$$(1)_2 : x_0$$
$$(0)_2 : 0$$

The expression of $c_n^y$ can be deduced as :

| $y\backslash I$ | $(1)_2$ | $(0)_2$ |
|---|---|---|
| $(11)_2$ | 1 | 0 |
| $(10)_2$ | 0 | 0 |

In the case $n = 2$, $x$, $y \to x + y = (x_1 y_1 \oplus x_1 x_0 y_0 \oplus x_0 y_1 y_0, x_1 \oplus y_1 \oplus x_0 y_0, x_0 \oplus y_0)$, and therefore :

| | | | | | |
|---|---|---|---|---|---|
| $(11)_2 :$ | $x_1$ | $\oplus$ | $x_0$ | $\oplus$ | $x_1 x_0$ |
| $(10)_2 :$ | $x_1$ | | | | |
| $(01)_2 :$ | | | | | $x_1 x_0$ |
| $(00)_2 :$ | 0 | | | | |

The expression of $c_n^y$ can be then deduced as :

| $y\backslash I$ | $(11)_2$ | $(10)_2$ | $(01)_2$ | $(00)_2$ |
|---|---|---|---|---|
| $(11)_2$ | 1 | 1 | 1 | 0 |
| $(10)_2$ | 0 | 1 | 0 | 0 |
| $(01)_2$ | 1 | 0 | 0 | 0 |
| $(00)_2$ | 0 | 0 | 0 | 0 |

In the case $n = 3$, the expression of $c_n^y$ is given by :

| $y\backslash I$ | $(111)_2$ | $(110)_2$ | $(101)_2$ | $(100)_2$ | $(011)_2$ | $(010)_2$ | $(001)_2$ | $(000)_2$ |
|---|---|---|---|---|---|---|---|---|
| $(111)_2$ | 1 | 1 | 1 | 1 | 1 | 1 | 1 | 0 |
| $(110)_2$ | 0 | 1 | 0 | 1 | 0 | 1 | 0 | 0 |
| $(101)_2$ | 1 | 0 | 0 | 1 | 1 | 0 | 0 | 0 |
| $(100)_2$ | 0 | 0 | 0 | 1 | 0 | 0 | 0 | 0 |
| $(011)_2$ | 1 | 1 | 1 | 0 | 0 | 0 | 0 | 0 |
| $(010)_2$ | 0 | 1 | 0 | 0 | 0 | 0 | 0 | 0 |
| $(001)_2$ | 1 | 0 | 0 | 0 | 0 | 0 | 0 | 0 |
| $(000)_2$ | 0 | 0 | 0 | 0 | 0 | 0 | 0 | 0 |

In the case $n = 4$, $c_n^y(x_{n-1}, \ldots, x_0)$ is defined by:

$$c_n^y(x_{n-1}, \ldots, x_0) = MAJ\left(x_{n-1}, y_{n-1}, c_{n-1}^{y_{n-2}, \ldots, y_0}(x_{n-2}, \ldots, x_0)\right)$$

$$= x_{n-1}\, y_{n-1} \oplus (x_{n-1} \oplus y_{n-1})c_{n-1}^{y_{n-2}, \ldots, y_0}(x_{n-2}, \ldots, x_0) \tag{17}$$

Two cases can be considered:

- If $y_{n-1} = 0$ (lower $2^{n-1}$ rows), then $c_n^y = x_{n-1}c_{n-1}^{y_{n-2}, \ldots, y_0}(x_{n-2}, \ldots, x_0)$, which is null if $x_{n-1} = 0$ and is equal to the monomials of $c_{n-1}^{y_{n-2}, \ldots, y_0}(x_{n-2}, \ldots, x_0)$ multiplied by $x_{n-1}$ otherwise. Therefore, the horizontal concatenation of a copy-and-paste of the $n$ - 1 quadrant, with an empty quadrant (i.e., a zero matrix of size $2^{n-1} \times 2^{n-1}$).
- If $y_{n-1} = 1$ (upper $2^{n-1}$ rows), then:

$$c_n^y = x_{n-1} \oplus (x_{n-1} \oplus 1)c_{n-1}^{y_{n-2}, \ldots, y_0}(x_{n-2}, \ldots, x_0) \tag{18A}$$

$$c_n^y = x_{n-1}c_{n-1}^{y_{n-2}, \ldots, y_0}(x_{n-2}, \ldots, x_0) \oplus x_{n-1} \oplus c_{n-1}^{y_{n-2}, \ldots, y_0}(x_{n-2}, \ldots, x_0) \tag{18B}$$

Expression 18(B) can be therefore decomposed in terms of ANF, as:

1. A first term $x_{n-1}c_{n-1}^{y_{n-2}, \ldots, y_0}(x_{n-2}, \ldots, x_0)$ which is the copy-and-paste of the $n$ - 1 quadrant in the top right position, which the exception of the monomial at position $(10 \ldots 0)_2$ which has been added.
2. A second term $x_{n-1}$;

3. A third term $c_{n-1}^{y_{n-2}, \ldots, y_0}(x_{n-2}, \ldots, x_0)$, which are monomials which do not contain $x_{n-1}$ and hence a copy-and-paste of the $n$ - 1 quadrant in the top right position.

In this case, the expression of $c_4^y$ is given by the following matrix:

| y \ I | $(1111)_2$ | $(1110)_2$ | $(1101)_2$ | $(1100)_2$ | $(1011)_2$ | $(1010)_2$ | $(1001)_2$ | $(1000)_2$ | $(0111)_2$ | $(0110)_2$ | $(0101)_2$ | $(0100)_2$ | $(0011)_2$ | $(0010)_2$ | $(0001)_2$ | $(0000)_2$ |
|---|---|---|---|---|---|---|---|---|---|---|---|---|---|---|---|---|
| $(1111)_2$ | 1 | 1 | 1 | 1 | 1 | 1 | 1 | 1 | 1 | 1 | 1 | 1 | 1 | 1 | 1 | 0 |
| $(1110)_2$ | 0 | 1 | 0 | 1 | 0 | 1 | 0 | 1 | 0 | 1 | 0 | 1 | 0 | 1 | 0 | 0 |
| $(1101)_2$ | 1 | 0 | 0 | 1 | 1 | 0 | 0 | 1 | 1 | 0 | 0 | 1 | 1 | 0 | 0 | 0 |
| $(1100)_2$ | 0 | 0 | 0 | 1 | 0 | 0 | 0 | 1 | 0 | 0 | 0 | 1 | 0 | 0 | 0 | 0 |
| $(1011)_2$ | 1 | 1 | 1 | 0 | 0 | 0 | 0 | 1 | 1 | 1 | 1 | 0 | 0 | 0 | 0 | 0 |
| $(1010)_2$ | 0 | 1 | 0 | 0 | 0 | 0 | 0 | 1 | 0 | 1 | 0 | 0 | 0 | 0 | 0 | 0 |
| $(1001)_2$ | 1 | 0 | 0 | 0 | 0 | 0 | 0 | 1 | 1 | 0 | 0 | 0 | 0 | 0 | 0 | 0 |
| $(1000)_2$ | 0 | 0 | 0 | 0 | 0 | 0 | 0 | 1 | 0 | 0 | 0 | 0 | 0 | 0 | 0 | 0 |
| $(0111)_2$ | 1 | 1 | 1 | 1 | 1 | 1 | 1 | 0 | 0 | 0 | 0 | 0 | 0 | 0 | 0 | 0 |
| $(0110)_2$ | 0 | 1 | 0 | 1 | 0 | 1 | 0 | 0 | 0 | 0 | 0 | 0 | 0 | 0 | 0 | 0 |
| $(0101)_2$ | 1 | 0 | 0 | 1 | 1 | 0 | 0 | 0 | 0 | 0 | 0 | 0 | 0 | 0 | 0 | 0 |
| $(0100)_2$ | 0 | 0 | 0 | 1 | 0 | 0 | 0 | 0 | 0 | 0 | 0 | 0 | 0 | 0 | 0 | 0 |
| $(0011)_2$ | 1 | 1 | 1 | 0 | 0 | 0 | 0 | 0 | 0 | 0 | 0 | 0 | 0 | 0 | 0 | 0 |
| $(0010)_2$ | 0 | 1 | 0 | 0 | 0 | 0 | 0 | 0 | 0 | 0 | 0 | 0 | 0 | 0 | 0 | 0 |
| $(0001)_2$ | 1 | 0 | 0 | 0 | 0 | 0 | 0 | 0 | 0 | 0 | 0 | 0 | 0 | 0 | 0 | 0 |
| $(0000)_2$ | 0 | 0 | 0 | 0 | 0 | 0 | 0 | 0 | 0 | 0 | 0 | 0 | 0 | 0 | 0 | 0 |

It can be noticed that in the above matrix, if the first row and the last column are suppressed, the resulting $(2^{n-1} \times$

$2^{n-1}$) matrix is symmetrical.

The ANF of the carry generate by $x \mapsto x + y$ can be defined. The ANF coefficients of the carry generated by the addition function are denoted $a_I$, namely:

$$c_n^y(x) = \bigoplus_{I \in \mathbb{F}_2^n} x^I a_I(y)$$

The ANF coefficients $a_I$ are defined as follows:

$$\forall y \in \mathbb{F}_2^y, a_\emptyset(y) = 0 \text{ and } a_I(y) = y^{dec(I)}, \text{ when } I \neq \emptyset.$$

The decrement function is defined as:

$$Dec : \mathrm{P}(\{0, \dots, n-1\}) \setminus \emptyset \to \mathrm{P}(\{0, \dots, n-1\})$$
$$I \to \psi^{-1}(\psi(I) - 1)$$

The function $\psi$ is the bijection defined as:

$$\psi : \mathrm{P}(\{0, \dots, n-1\}) \to \mathrm{P}(\{0, \dots, n-1\})$$
$$I \to \sum_{i \in I} 2^i$$

The inverse of the above matrix is:

$$\begin{pmatrix} 1 & 1 & 1 & 1 & 1 & 1 & 1 \\ 0 & 1 & 0 & 1 & 0 & 1 & 0 \\ 1 & 0 & 0 & 1 & 1 & 0 & 0 \\ 0 & 0 & 0 & 1 & 0 & 0 & 0 \\ 1 & 1 & 1 & 0 & 0 & 0 & 0 \\ 0 & 1 & 0 & 0 & 0 & 0 & 0 \\ 1 & 0 & 0 & 0 & 0 & 0 & 0 \end{pmatrix}^{-1} = \begin{pmatrix} 0 & 0 & 0 & 0 & 0 & 0 & 1 \\ 0 & 0 & 0 & 0 & 0 & 1 & 0 \\ 0 & 0 & 0 & 0 & 1 & 1 & 1 \\ 0 & 0 & 0 & 1 & 0 & 0 & 0 \\ 0 & 0 & 1 & 1 & 0 & 0 & 1 \\ 0 & 1 & 0 & 1 & 0 & 1 & 0 \\ 1 & 1 & 1 & 1 & 1 & 1 & 1 \end{pmatrix}.$$

This inverse matrix takes monomials $\phi_u$, and returns the y for which the CARRY of $x \mapsto x + y$ shall be taken to implement the function leveraging ANF representation.

The matrix may now be expended this matrix by one row (for the constant 1) and one column (for XOR by 1). This yields:

$$Ci = \begin{pmatrix} 0 & 0 & 0 & 0 & 0 & 0 & 1 & \vdots & 0 \\ 0 & 0 & 0 & 0 & 0 & 1 & 0 & \vdots & 0 \\ 0 & 0 & 0 & 0 & 1 & 1 & 1 & \vdots & 0 \\ 0 & 0 & 0 & 1 & 0 & 0 & 0 & \vdots & 0 \\ 0 & 0 & 1 & 1 & 0 & 0 & 1 & \vdots & 0 \\ 0 & 1 & 0 & 1 & 0 & 1 & 0 & \vdots & 0 \\ 1 & 1 & 1 & 1 & 1 & 1 & 1 & \vdots & 0 \\ \cdots & \cdots & \cdots & \cdots & \cdots & \cdots & \cdots & \vdots & \cdots \\ 0 & 0 & 0 & 0 & 0 & 0 & 0 & \vdots & 1 \end{pmatrix}$$

The Möbius transformation is given by the definition Def.1 in Anubhab Baksi, Sylvain Guilley, Ritu Ranjan Shrivastwa, and Sofiane Takarabt. From Substitution Box To Threshold. IACR Cryptol. ePrint Arch., page 633, 2023.

The complete matrices for the Möbius transformation ($M \times C_i$) is for example:

- for $n = 0$, $M \times C_i = (1)$;

- for $n = 1$, $M \times C_i = \begin{pmatrix} 1 & 0 \\ 1 & 1 \end{pmatrix}$

- for $n = 2$, $M \times C_i = \begin{pmatrix} 0 & 0 & 1 & 0 \\ 0 & 1 & 1 & 0 \\ 1 & 1 & 0 & 0 \\ 1 & 0 & 0 & 1 \end{pmatrix}$

- for $n = 3$, $M \times C_i =$

$$\begin{pmatrix} 0 & 0 & 0 & 0 & 0 & 0 & 1 & 0 \\ 0 & 0 & 0 & 0 & 0 & 1 & 1 & 0 \\ 0 & 0 & 0 & 0 & 1 & 1 & 0 & 0 \\ 0 & 0 & 0 & 1 & 1 & 0 & 0 & 0 \\ 0 & 0 & 1 & 1 & 0 & 0 & 0 & 0 \\ 0 & 1 & 1 & 0 & 0 & 0 & 0 & 0 \\ 1 & 1 & 0 & 0 & 0 & 0 & 0 & 0 \\ 1 & 0 & 0 & 0 & 0 & 0 & 0 & 1 \end{pmatrix}$$

- for $n = 4$, $M \times C_i =$

$$\begin{pmatrix} 0 & 0 & 0 & 0 & 0 & 0 & 0 & 0 & 0 & 0 & 0 & 0 & 0 & 0 & 1 & 0 \\ 0 & 0 & 0 & 0 & 0 & 0 & 0 & 0 & 0 & 0 & 0 & 0 & 0 & 1 & 1 & 0 \\ 0 & 0 & 0 & 0 & 0 & 0 & 0 & 0 & 0 & 0 & 0 & 0 & 1 & 1 & 0 & 0 \\ 0 & 0 & 0 & 0 & 0 & 0 & 0 & 0 & 0 & 0 & 0 & 1 & 1 & 0 & 0 & 0 \\ 0 & 0 & 0 & 0 & 0 & 0 & 0 & 0 & 0 & 0 & 1 & 1 & 0 & 0 & 0 & 0 \\ 0 & 0 & 0 & 0 & 0 & 0 & 0 & 0 & 0 & 1 & 1 & 0 & 0 & 0 & 0 & 0 \\ 0 & 0 & 0 & 0 & 0 & 0 & 0 & 0 & 1 & 1 & 0 & 0 & 0 & 0 & 0 & 0 \\ 0 & 0 & 0 & 0 & 0 & 0 & 0 & 1 & 1 & 0 & 0 & 0 & 0 & 0 & 0 & 0 \\ 0 & 0 & 0 & 0 & 0 & 0 & 1 & 1 & 0 & 0 & 0 & 0 & 0 & 0 & 0 & 0 \\ 0 & 0 & 0 & 0 & 0 & 1 & 1 & 0 & 0 & 0 & 0 & 0 & 0 & 0 & 0 & 0 \\ 0 & 0 & 0 & 0 & 1 & 1 & 0 & 0 & 0 & 0 & 0 & 0 & 0 & 0 & 0 & 0 \\ 0 & 0 & 0 & 1 & 1 & 0 & 0 & 0 & 0 & 0 & 0 & 0 & 0 & 0 & 0 & 0 \\ 0 & 0 & 1 & 1 & 0 & 0 & 0 & 0 & 0 & 0 & 0 & 0 & 0 & 0 & 0 & 0 \\ 0 & 1 & 1 & 0 & 0 & 0 & 0 & 0 & 0 & 0 & 0 & 0 & 0 & 0 & 0 & 0 \\ 1 & 1 & 0 & 0 & 0 & 0 & 0 & 0 & 0 & 0 & 0 & 0 & 0 & 0 & 0 & 0 \\ 1 & 0 & 0 & 0 & 0 & 0 & 0 & 0 & 0 & 0 & 0 & 0 & 0 & 0 & 0 & 1 \end{pmatrix}$$

Considering the example of the complete transformation, for $n = 3$, for $f: \mathbb{F}_2^n \longmapsto \mathbb{F}$ a Boolean function, then:

$(f(111), \dots, f(000)) \, M \times C_i$

$= (f(000) \oplus f(001), f(001) \oplus f(010), f(010) \oplus f(011), f(011) \oplus f(100), f(100)$

$\oplus f(101), f(101) \oplus f(110), f(110) \oplus f(111), f(000)$

Therefore, $\forall x \in \mathbb{F}_2^n$ :

$$f(x) = \big(f(000) \oplus f(001)\big)c_n^{(111)}(x) \oplus \big(f(001) \oplus f(010)\big)c_n^{(110)}(x) \oplus$$
$$\big(f(010) \oplus f(011)\big)c_n^{(101)}(x) \oplus \big(f(011) \oplus f(100)\big)c_n^{(100)}(x) \oplus$$
$$\big(f(100) \oplus f(101)\big)c_n^{(011)}(x) \oplus \big(f(101) \oplus f(110)\big)c_n^{(010)}(x) \oplus$$
$$\big(f(110) \oplus f(111)\big)c_n^{(001)}(x) \oplus f(111)$$
$$= f(000) \oplus \bigoplus_{y=1}^{2^n-1} \big(f(y) \oplus f(y-1)\big)\, c_n^{2^n-y}(x).$$

Accordingly, the "Guilley Transform" of a Boolean function $f$ for any input $x \in \mathbb{F}_2^n$ is defined according to equation (19):

$$f(x) = f(0) \oplus \bigoplus_{y=1}^{2^n-1} \big(f(y) \oplus f(y-1)\big)c_n^{2^n-y}(x) \quad (19)$$

Equation (19) represents the Guilley Transform found out by the inventors to speed the evaluation of any Boolean function $f$ in $x$, $f$ being defined from the n-dimensional vector space $\mathbb{F}_2^n$ over the prime field vector space $\mathbb{F}_2$, in the variable $x$, such that $x$ is a vector of length $n$ over the vector space $\mathbb{F}_2^n$.

According to the embodiments of the invention, the evaluation device 20 is configured to exploit the Guilley transform of any $(n-1)$-Boolean function $f$ (i.e. elements of $\mathcal{BF}_n$, the set of $n \mapsto 1$ bit functions) according to equation (19). The evaluation device 20 can then evaluate the Boolean functions, on computers manipulating at least $n$-bit words.

Expression (19) involves a differential (difference of values):

$$\Delta f(y) = f(y) \oplus f(y-1) \quad (20)$$

Equation (19) can therefore be rewritten:

$$f(x) = f(0) \oplus \bigoplus_{y=1}^{2^n-1} \Delta f(y)c_n^{2^n-y}(x)$$

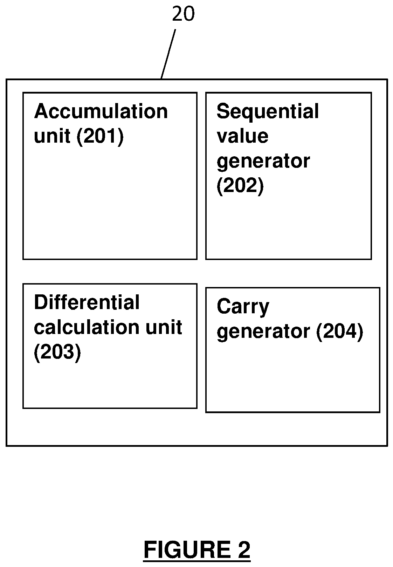

Figure 2 depicts the structure of the Boolean function evaluation device 20, according to some embodiments. Advantageously, the evaluation device 20 exploits the Guilley Transform defined by equation (19).

The evaluation device 20 may comprise an accumulation unit 201 configured to perform an accumulation by XOR of the summation of Equation (19).

The evaluation device 20 may further comprise a sequential value generator 202 configured to generate sequential values of the dummy variable y (also called 'intermediary' variable), from $y = 1$ to $y = 2^n - 1$. The sequential value generator 202 may be implemented as a counter.

The evaluation device 20 may also comprise a carry generator 204 configured to compute the arithmetic carry $c_n^{2^n-y}$ that is "conditioned" to the fact that the differential $\Delta f(y)$ is true. The carry generator 204 uses pre-computed values of $\Delta f(y)$ for each value of $y$ that may be pre-computed by a differential calculation unit 203.

The input $x \in \mathbb{F}_2^n$ is submitted to the carry generator 204, whilst the output is ready after $2^n - 1$ clock cycles in the accumulation unit 201. The sequential value generator 202 acts as a control engine.

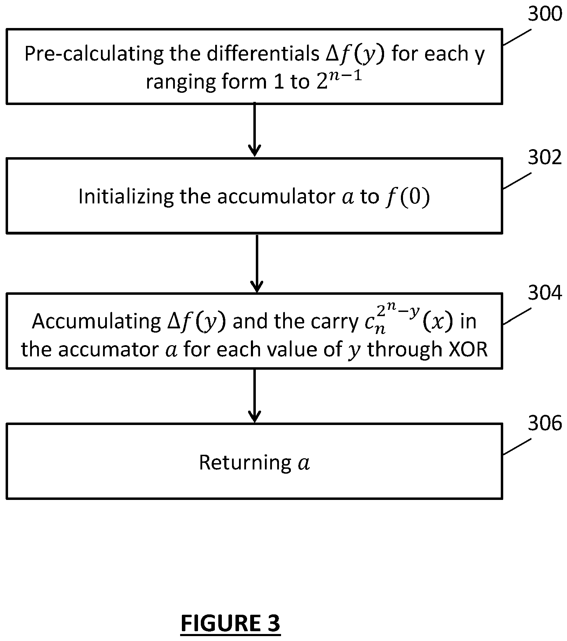

Figure 3 depicts a method of evaluating a Boolean function f in $x$, implemented by the evaluation device, according to some embodiments.

The method consists in evaluating the Boolean function $f$ in $x$ using the Guilley Transform defined by equation 19.

To evaluate a Boolean function $f$ in $x$, in step 300, the XOR ($\oplus$ symbol) between the differences of values $f(y)$ and $f$

($y$ - 1), according to equation (20), for y ranging from 1 to $2^{n-1}$, are precalculated, which provides the differentials $\Delta f(y) = f(y) \oplus f(y-1)$, y being a dummy variable (or "intermediary variable") different from 0 (y $\neq$ 0).

For each $x$ (block 301) on which the Boolean function $f$ is to be evaluated:

- an accumulator variable denoted '$a$' is initialized with the value $f(0)$ in step 302;

- For each value of $y$, the value $\Delta f(y)$ precomputed for y and the carry $c_n^{2^n-y}(x)$ from the addition of $x$ to $2^n$ - $y$ are accumulated in the variable $a$ through a XOR operation, in step 304; Step 304 corresponds to the evaluation of the term $\bigoplus_{y=1}^{2^n-1}\left(f(y)\oplus f(y-1)\right)c_n^{2^n-y}(x)$ of equation (19),

- In step 306, the value of the accumulator variable $a$ is returned, which corresponds to the result of the evaluation of the Boolean function f.

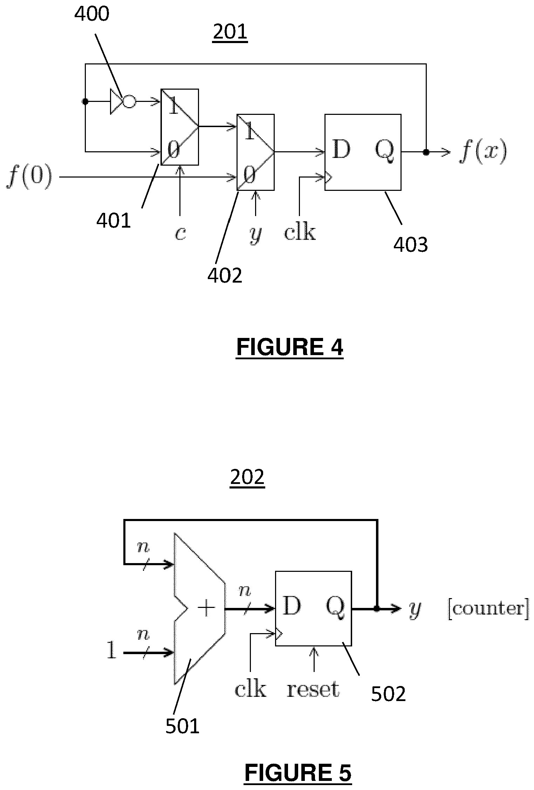

Figures 4 to 6 depicts hardware implementations of the different blocks of the evaluation device 20, according to some embodiments.

In particular, figure 4 depicts a hardware implementation of the accumulation unit 201 configured to perform an accumulation by XOR of the summation in Equation (19), according to some embodiments.

Figure 5 depicts a hardware implementation of the sequential value generator 202 is configured to generate sequential values of the dummy loop index $y$ (called 'dummy' variable or 'intermediary' variable), according to some embodiments.

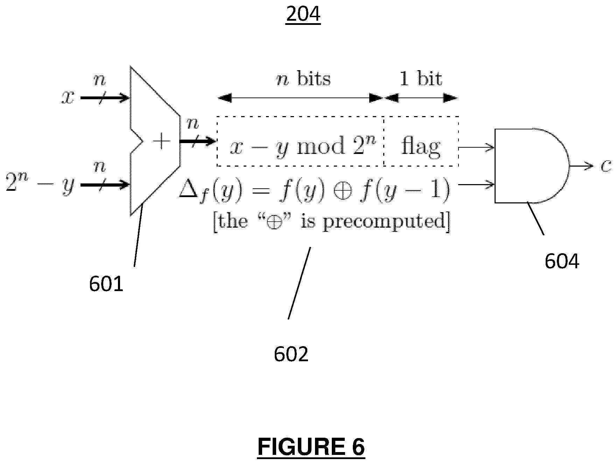

Figure 6 depicts a hardware implementation of the carry generator 204 configured to compute the arithmetic carry that is "conditioned" (by an AND gate) to the fact that the differential $\Delta f(y)$ is true, according to some embodiments.

In figures 4 to 6, the global signals comprise:

- a 'reset' signal which initializes the memory contents to zero.

- a clock signal 'clk' which cadences the operations.

The signal c represents the carry signal.

Further, the wires represented in figure 4 to 6 :

- carry bits when represented as thin wires;
- carry n-bit buses when represented as thick wires.

The following symbols are further used:

- a DFF memory (D Flip Flop) 403 represented in figure 4 as a square with an incoming arrow for the system clock ('clk' signal), D being the data input and Q the memorized output;

- The component with a "+" symbol inside, such as component 501 in figure 5 and component 601 in figure 6, designates an arithmetic adder, where the carry is dropped unless indicated. In particular, in the component 501 of figure 5, there is no need for a carry, as the dummy value $y$ (also called 'intermediary value') ranges from 1 to $2^n$ - 1, thereby fitting on $n$ bits. However, in component 601 of figure 6, the carry is needed as it is the working factor in equation (19).

- The boxes including a 0 and a 1 inside such as components 401 and 402 of figure 4 represent multiplexors, configured to select the input 0 (respectively 1) if the signal beneath (signal $c$ for block 401 and the signal $y$ for block 402) is equal to 0 (respectively 1);

- The triangle followed by a small circle 400 is an inverter (logical not function), in figure 4;

- a AND gate, such as component 604 of figure 6, is represented as a rectangle ending with a round.

The function of the accumulation unit 201 of figure 4 is to toggle the output each time the input c is equal to '1' (when the accumulator is active, i.e., when $y \neq 1$). The output presents the valid result $f(x)$ after $2^n$ - 1 clock cycles.

During those clock cycles, the sequential value generator 202 of figure 5 is configured to generate consecutive values of the counter y, starting from '1' at reset to $2^n$ - 1.

The carry generator 204 of figure 6 is configured to determine the term $\Delta f(y)c_n^{2^n-y}(x)$ of figure (19). In this respect, the carry $c_n^{2^n-y}(x)$ is computed from the sum of $x$ with $2^n - y$. The value $2^n - y$ is equal to $\neg y + 1$. The sum fits on $n + 1$ bits. The $n$ first bits (of lowest weight) encode in binary format the value of $x + (2^n - y) = 2^n + (x - y)$ on $n$ bits, that is $x - y \bmod 2^n$. The last bit, namely the carry of the addition, is precisely the expected value $c_n^{2^n-y}(x)$. A carry flag associated with this carry is stored in a "flag" register. The carry flag is a single bit stored in the flag register to indicate that the arithmetic carry has been generated out of the most significant arithmetic logic unit (ALU) bit position. The content of the 'flag' register can be fetched and ANDed with $\Delta f(y)$ (i.e. an AND operation is performed between $c_n^{2^n-y}(x)$ and $\Delta f(y)$ to determine $\Delta f(y)c_n^{2^n-y}(x)$), which provides the control signal c. The control signal c represents is the selection signal on the accumulation unit 201 of figure 4, which decides whether the partial accumulation is inverted (or toggled) or not (kept identical).

The processing system 100 may be implemented in a computing system comprising one or more processors for executing instructions of a computer program, and an arithmetic logic unit (ALU) forming a combinational digital circuit configured to performs arithmetic and bitwise operations on integer binary numbers.

Advantageously, the hardware blocks represented in figure 4 may use the resources of the one or more processors. For example, in some embodiments, the sequential value generator 202 of figure 5 may consist in an auto-incrementation of a register containing the index of a "for" loop.

Further, in the hardware implementation of the arithmetic carry generator 204 represented in figure 6, the sum of $x$ and $y$ may be performed by the arithmetic addition of the Arithmetic and Logic Unit (ALU) block of the processor, whilst the bitwise product operation may be performed by the logic AND operation of the same ALU. The hardware implementation of the accumulation unit 204 of figure 4 may be performed in the processor user registers.

The AND gate is typically a Boolean condition, that can be executed in constant time leveraging the CMOVE instruction family (a cmove instruction uses the flags from a previous operation to determine if a move instruction should be done or not). By using the accumulation variable $a$, then conditionally in $\Delta f(y)$, the carry is added or not.

A computing system operates on n-bit vectors, which are termed:

- "bytes", when n = 8,
- "words", when n = 16,
- "double words", when n = 32,
- "quad words", when n = 64,
- "double quad words", when n = 128, etc.

Depending on the problem to solve, $(n - 1)$-Boolean functions with any of these bitwidth are practical to evaluate fast, according to the embodiments of the invention using the computing system ALU. The computing system may for example implement an Instruction Set Architecture (ISA) which includes the Addition with Carry (usually abridged "ADC"). Any of the bit vectors can be added, by arithmetic meaning, with an optional input carry. This allows to chain operations, for example, when executing elementary or more sophisticated additions in radix 2n. Indeed, it may occur that additions on long integers can be cut into smaller pieces (of $n$ bit width each), nonetheless by taking care of the carry propagation. Namely, operations on low weights produce output carries that are fed as input carries in the subsequent operations of higher weight. This means that the computer system Arithmetic and Logic Unit (ALU) is adapted to manage the execution of addition with the generation of an overflow carry.

If two $n$-bit operands $x$ and y fit on $n$ bits, that is $0 \leq x$, and $y \leq 2^n - 1$, then their sum fits on $n + 1$ bits (even if it is considered an input carry $c_{in} \in \mathbb{F}_2$); indeed, $0 \leq x + y + c_{in} \leq 2 \times (2^n - 1) + 1 = 2^{n+1} - 1$. As the computer registers are limited to $n$ bits, the ADC result consists in a main result $x + y + c_{in} \bmod 2^n$ which fits on $n$ bits, and an output carry $c_{out} = \lfloor (x + y + c_{in})/2^n \rfloor \in \{0,1\}$ with $\{0,1\} = \mathbb{F}_2$. In some embodiment, this output carry $c_{out}$ may be stored (alongside with other status bits) in a register, called "flag" register by setting the CARRY bit if $c_{out} = 1$. Advantageously, the use of CARRY operations to evaluate a Boolean function does not add extra computational costs to the computer system implementing the processing system as most of the computer systems are already configured to compute a CARRY operation natively. In addition, the CARRY operation is silicon optimized in that it can execute in only one clock cycle.

In some embodiments, the evaluation device 20 may exploit a Single-Instruction-Multiple-Data (SIMD) evaluation.

Indeed, it can be noticed that the control flow in the hardware implementation of figures 4 to 6 is independent of the data (namely, input $x$). Such extension allows to evaluate f on a plurality of $K$ values of $x$, denoted $x_k$ with $k$ being comprised between 1 and $K$ ($1 \leq k \leq K$), in parallel, whilst factoring the control logic.

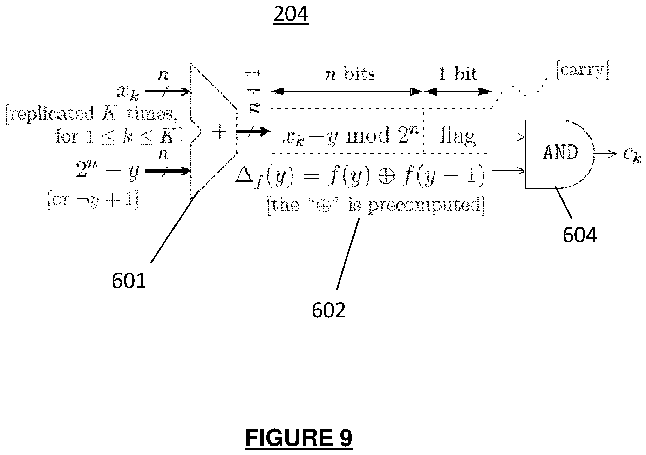

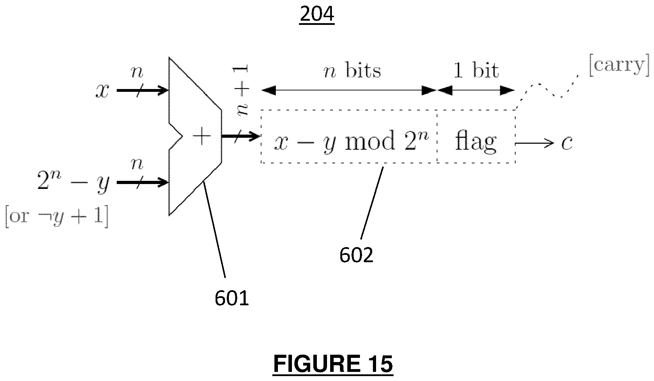

In figures 4 to 15, similar references are used to designate equivalent components.

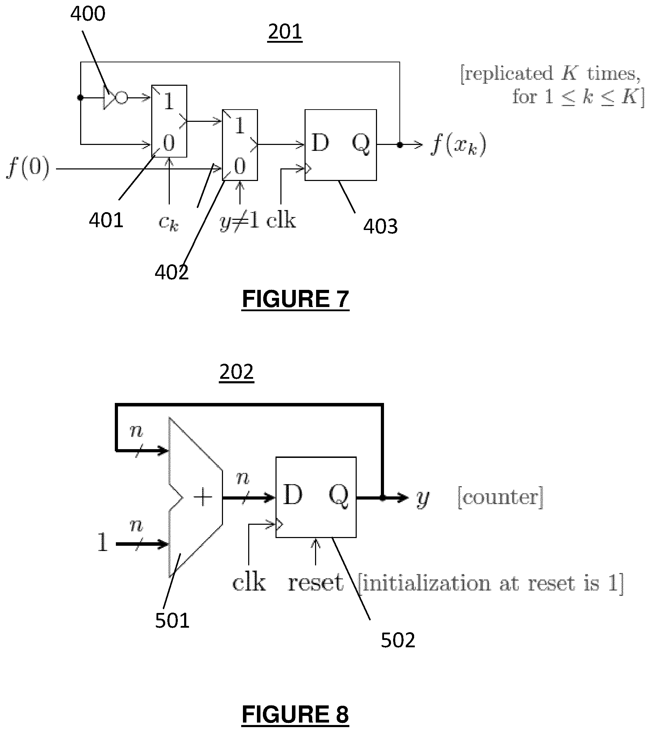

Figures 7, 8 and 9 illustrate different blocks of a SIMD based implementation of the evaluation device 20, according to some embodiments. Such implementation is particularly adapted to computer system architectures whereby several ADC can be executed in parallel. Figures 7, 8 and 9 represents the different part of the parallel implementation of the fast Boolean function f evaluation in K input values $x_k$ with $1 \leq k \leq K$. Figures 4, 6 and 7 correspond to an implementation of the SIMD implementation of figures 7 to 9 with a $K = 1$ structure.

The "Single Instruction" is the part 202 of the SIMD implementation of the evaluation device 20, whilst the "Multiple Data" consists in the vectorized parts 201 and 204 of the SIMD implementation of the evaluation device 20.

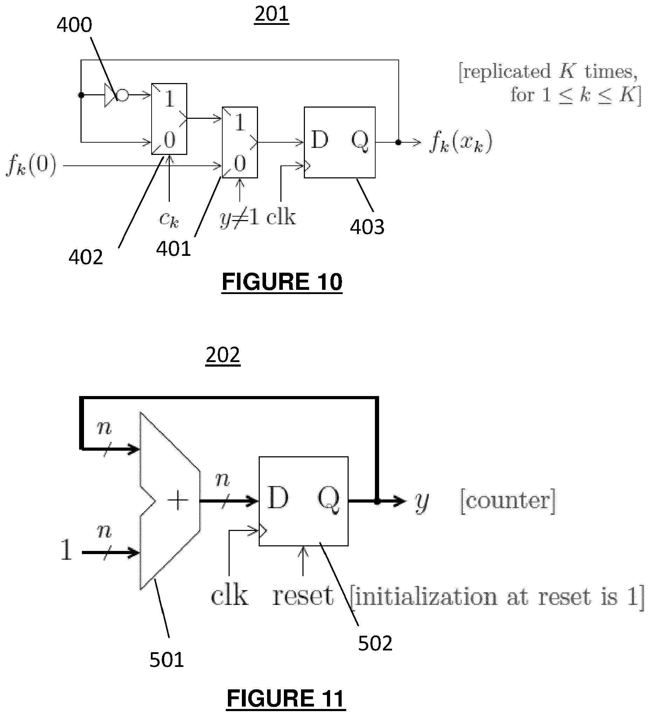

The SIMD architecture can be extended from the function $f$ input to a parallel computation of several functions $f_k$ ($1 \leq k \leq K$) as represented in figures 10, 11 and 12.

Figures 10, 11 and 12 correspond to the different parts of the parallel SIMD hardware implementation of the evaluation device 20, in an embodiment where $K$ fast Boolean functions $f_k$ are evaluated in $K$ input values $x_k$ ($1 \leq k \leq K$), based on the function $f$ SIMD architecture parallelized only on data $x_k$ represented by the hardware parts of Figures 7, 8 and 9.

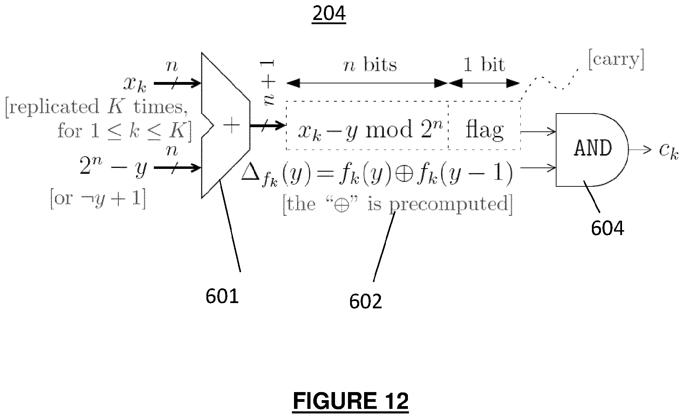

In figures 10 and 12, the hardware related to the function $f$ is specialized. In figure 10, in particular, the value of $f_k$ (0) is input for each function $f_k$, which was not the case in the case in the corresponding implementation of the accumulation unit 201 of figure 7, which is valid for only one single function $f$ common for multiple input values $x_k$. In figure 12, the difference $\Delta f_k(y)$ is precomputed for each function $f_k$ as well.

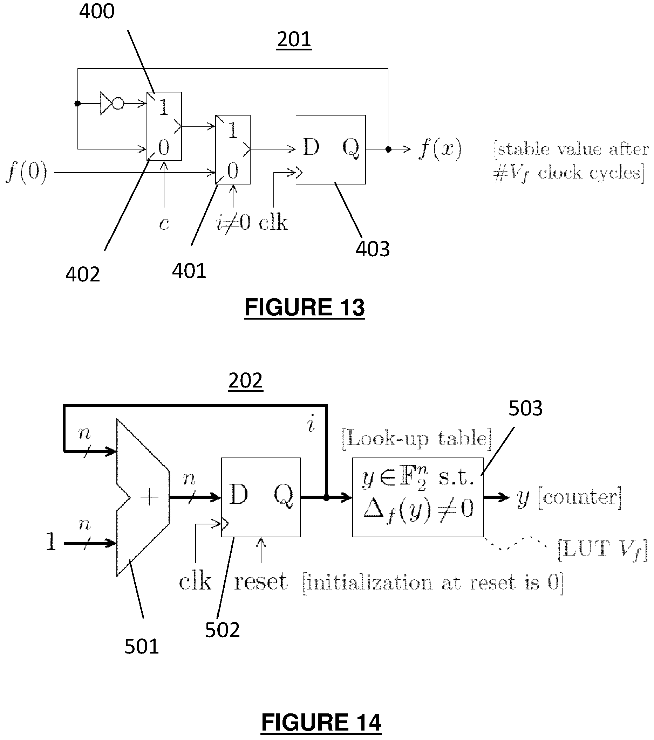

In some embodiments, the speed of the Boolean function evaluation can be further improved when the differential $\Delta f$ of the function $f$ is piecewise constant equal to zero. Indeed, in this case, the counter $y$ (intermediary variable) can be speed up over the zero intervals of $\Delta f$ as depicted by the hardware implementation of the evaluation device 20 represented by figures 13, 14 and 15. This technique will be referred to as a "compression of truth table differential". This may occur for instance on systems which need to operate on sparse data.

Figures 13, 14 and 15 represent more specifically a faster implementation of the fast evaluation device 20 configured to evaluate a Boolean function $f$ in $x$ (leveraging equation 19), when $\Delta f$ is sparse. When $\Delta f$ is sparse, it can be tabulated efficiently (space-wise) in a look-up-table (LUT) $V_f$ (i.e. a computer variation table of $f$) designated by reference 503 in figure 14. In this case, only the support of $\Delta f$, which represents the values of y such that $\Delta f$ is equal to 1, may be stored (which will be less than $2^n$) in a look-up table (LUT), and the accumulation is restricted to this support. In particular, the look-up-table (LUT) $V_f$ may be instantiated that translates addresses $i$ ($0 \leq i \leq \neq V_f$) in the hardware part corresponding to the sequential value generator 202. The guard "$\Delta f(.)$" is then no longer needed in the hardware part corresponding to the carry generator 204. Only the values of $y \in \mathbb{F}_2^n$ such that $\Delta f(y) = 1$ are conveyed to the accumulation unit 201. Therefore, this implementation depicted in figures 13, 14 and 15 is both lighter in terms of silicon resources and faster in terms of evaluation time (which is equal to $\neq V_f$ clock cycles instead of $2^n$ - 1).

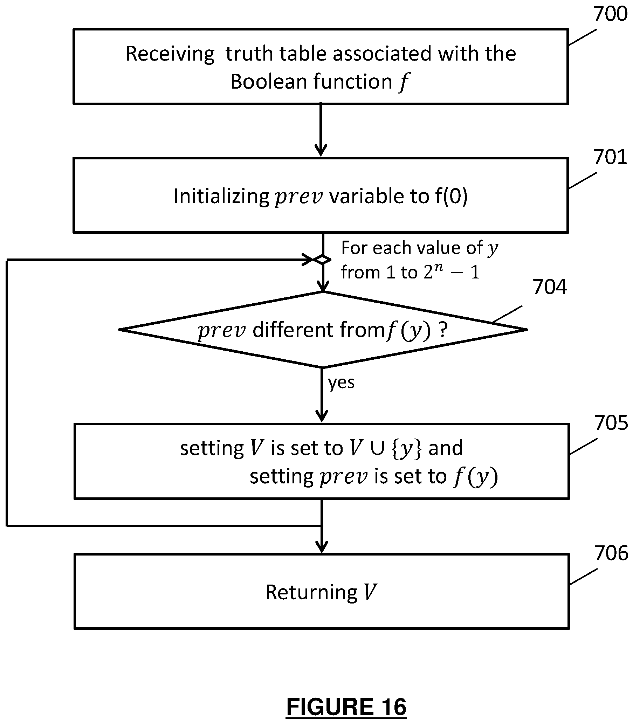

Figure 16 is a flowchart depicting the determination of the look-up-table $V_f$ of the Boolean function $f$, from the truth table associated with the function $f$.

In step 700, the truth table associated with the Boolean function $f$ is received.

In step 701, a *prev* variable is initialized to $f(0)$.

In step 704, for each value of the variable $y$ comprised between 1 and $2^n$ - 1 (block 702), if $f(y)$ is different from the current value of *prev* (block 705), then:

- A variable $V$ is set to $V$ u $\{y\}$ ($V \leftarrow V$ u $\{y\}$) and
- The variable *prev* is set to $f(y)$ (*prev* $\leftarrow f(y)$) .

Steps 704 and 705 are then iterated for the next value of $y$ ($y$ is incremented in step), using the current value of $V$ and *prev*.

When all the values of y have been processed, in step 706, the current value of $V$ is returned as the look-up-table $V_f$ of the Boolean function $f$.

In step 704, the variable *prev* may be alternatively set to $prev \oplus 1$ at each iteration of step 704 (*prev* $\leftarrow prev \oplus 1$ ).

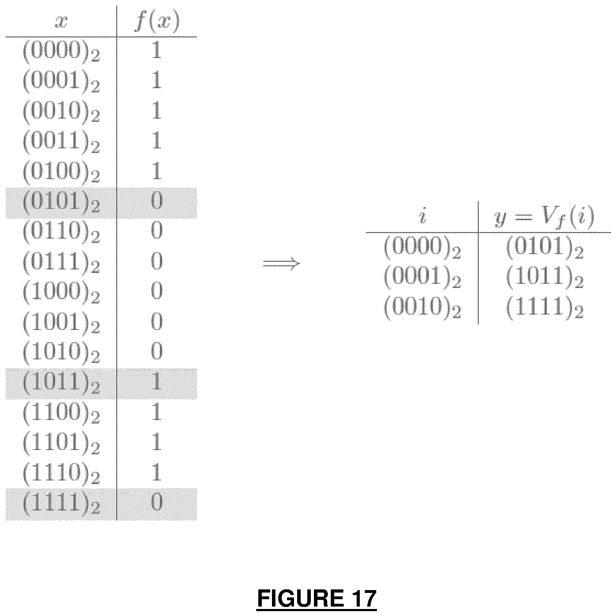

Figure 17 illustrates an exemplary computation of the look-up-table $V_f$ of a Boolean function $f$. At the left of figure 18, the function f is given for different values of $x$, and at the right of figure 18 the look-up-table $V_f$ (values $V_f(i)$) determined according to the method of figure 17 is given for different values of $i$.

Eventually, it can be noticed that the SIMD based embodiment of the evaluation device 20, (as illustrated by figures 7, 8 and 9) and the embodiment based on a precomputed LUT for $\Delta f$ support of the evaluation device 20 (as illustrated by figures 13, 14 and 15), may be also combined.

In the prior art solutions which perform an evaluation of Boolean functions using ANF, CNF or DNF are not computationally friendly. Indeed, they consist in the evaluation of monomials, maxtems or minterms. Specifically, the evaluation of the monomial $x^y$ in the case of ANF requires $w_H(y) - 1$ logical *AND* (where $w_H$ is the Hamming weight function, namely the function that counts the number of 1s in one word). Thus, in average, assuming $y$ uniformly distributed in $\mathbb{F}_2^n$, the complexity $C$ in the ANF prior art approach is equal to:

$$C = \frac{1}{2^n} \sum_{y=0}^{2^n-1} (w_H(y) - 1) = n/2 - 1$$

In contrast, the evaluation device (20) and the evaluation method according to the embodiments of the disclosure provide a complexity limited to one operation (CARRY) only.

Advantageously, intermediate bits of the addition of $x$ and $y$ (which are words on $n$ bits), that is the bits of index $i$ in general ($0 \le i \le n$), can be used as the CARRY. This allows generating functions $f$ operating on $i$ bits.

In equation (18), the basis elements are (*by design*) the natural carry of arithmetic additions. Indeed, on any processors, overflow in arithmetic addition is memorized in a flag register, that can be read to retrieve whether or not a carry has been generated. Such generation of CARRY is typically carried out by the ADC (Add with Carry) instruction.

Considering the example of the Boolean function $f$ given in figure 17, such that $f: \mathbb{F}_2^4 \to \mathbb{F}_2$, the function f can be formulated as follow according to the prior art approaches (ANF, CNF, DNF) and the Guilley-transform according to the embodiments of the disclosure:

According to conventional ANF form, $f$ is expressed as follows :

$$f(x = x_3\,x_2\,x_1\,x_0 \oplus x_3\,x_2\,x_1 \oplus x_3\,x_2\,x_0 \oplus x_3\,x_2 \oplus x_3\,x_1\,x_0 \oplus x_3 \oplus x_2\,x_1\,x_0 \oplus x_2\,x_1 \oplus x_2\,x_0 \oplus 1)$$

According to conventional CNF form, $f$ is expressed as follows:

$$f(x) = (x_3 \vee \bar{x}_2 \vee \bar{x}_0)(x_3 \vee \bar{x}_2 \vee \bar{x}_1)(\bar{x}_2 \vee \bar{x}_1 \vee \bar{x}_0)(\bar{x}_3 \vee x_2 \vee x_1)(\bar{x}_3 \vee x_2 \vee x_0)$$

According to DNF form, $f$ is expressed as follows:

$$f(x) = \bar{x}_3\bar{x}_2 \oplus x_3\,x_2\,\bar{x}_1 \oplus x_3\,x_2\,\bar{x}_0 \oplus \bar{x}_3\,\bar{x}_1\,\bar{x}_0 \oplus \bar{x}_2\,x_1\,x_0$$

According to the Guilley-transform defined by equation (19):

$$f(x) = 1 \oplus CARRY(x, 11) \oplus CARRY(x, 4) \oplus CARRY(x, 1) \quad (20)$$

With *CARRY*(x, y) being defined as:

$$CARRY(x, y) = c_4^y(x)$$

The ANF is obtained by the Möbius transform. The CNF and DNF are obtained manually by Karnaugh map. It should be noted that the constant 11, 4 and 1 in expression (20) correspond to 16-$y$ in the admissible values of the look-up table $V_f$, namely $Im(V_f) = \{5,12,15\}$. Moreover, another advantage of the Boolean function evaluation device and method according to the embodiments of the disclosure is that the value of $x$ can be laid out in one word (or double-word, quad-word, etc.), which allows for faster computation, compared to ANF, CNF and DNF expressions, where the word $x$ shall be dispatch in $n$ registers. It should be further noticed that *CARRY*(x, y) can be determined in various ways. In one embodiment, *CARRY*(x, y) can be for example determined from carry flag by looking at the generated carry flag, and leveraging the ADC computer instruction. This is equivalent to testing for the condition $x + y \ge 2n$, that can be computed with a compared opcode (CMP) assuming that the register size is strictly larger than $n$.

The embodiments of the disclosure therefore exploit the property found out by the inventors according to which the XOR operation and the CARRY operation (the output carry of an addition with a nonzero constant) are both balanced operations and the reformulation of any Boolean function according to equation (19) to provide a system and a method of evaluating any Boolean function that allow to rebuild in constant time and efficiently the Boolean function (assuming "⊕ = 1", the least significant bit toggle function, is also available). Such XOR and CARRY operations are present on all computers and allow for a considerable speed-up of Boolean functions evaluation, whilst keeping them secret in the context of side-channel attacks. In some embodiments, a processor-independent constant time implementation may be used.

In addition to speeding the evaluation of Boolean function, the embodiments of the disclosure also ensure a constant timeness (of optimization in timing by dropping values of $\Delta f(y)$ which are null), a time-memory trade-off as the full lookup table of the target function shall not be known, and may leverage the SIMD architecture of computers, as carries can be generated in the middle of words, when Single Instruction Multiple Data (SIMD) instruction sets are used.

The invention can be used in cryptography (especially symmetric cryptography for substitution boxes in block ciphers, round function in hash functions and feedback logic in stream ciphers), in computer science (e.g., compilers - for representation of switch/case statements, SAT-solvers - for accelerating evaluation of formulas to be satisfied).

It could be extended to primitives other than $x \mapsto x+y$, namely $x \mapsto xy$ (arithmetic product, with a constant y).

The processing system 1 according to the embodiments of the invention may be used in various applications. For example, the processing system may be a cryptographic system, such as a cryptographic system implementing symmetric cryptography for substitution boxes in block ciphers, a round function in hash functions, or feedback logic in stream ciphers. The processing system may be a computing system such as a compiler (e.g. for representation of switch/case statements), a solver (e.g. SAT-solver) for accelerating evaluation of Boolean formulae to be satisfied), a computing system for obfuscation of programs configured to conceal functionality in unusual coding of Boolean function. According to another example, the processing system 1 may be a digital Signal Processing (DSP) for real-time data filtering. In this case, the evaluation device can use a filter having long runs of constants values, in which case the difference $\Delta f$ is null on large contiguous intervals, resulting in the XOR accumulation of equation 19 to be simplified (useless on intervals of '0'), as illustrated with the embodiment of figures 13, 14 and 15.

The values of the input $x$ to which the Boolean function $f$ is applied may represent specific data related to the application field of the processing system 1.

For example, in an application of the disclosure to the cryptographic field, the input $x$ to which the Boolean function $f$ is applied may be data represented as a binary string of information, aiming at being protected against illegitimate read-access, by encryption, and/or against illegitimate write-access ("manipulation") by MAC (Message Authentication Code) algorithms. In this case, the processing device 2 may implement encryption and/or MAC algorithms (forming the one or more processing operations) configured to leverage Boolean functions as part of their internal transforms. For instance, Substitution Boxes or even diffusion layers pertaining to encryption algorithms can be complex in terms of Boolean function expression. Further, some MAC algorithms may use hash functions. Although the combinatorial logic of the inner rounds of the hash-functions is usually less complex, it requires to be evaluated fast as they are a limiting factor for the overall speed. Another example is the specific case of stream ciphers used in encryption algorithms, where some state register is « filtered » by a Boolean function, as in GRAIN or TRIVIUM for instance. In particular, those algorithms can be themselves protected against implementation-level attacks (known as Side-Channel Attacks, or SCA), whereby the ability to evaluate efficiently Boolean functions is paramount. Indeed, protection against SCA, such as timing attacks, requires the execution time to be constant, irrespective of the actual value carried by $x$, and can happen on a shared version of $x$ (i.e., randomly split up multiple shares on which the computation is carried out in parallel, before a final reconciliation with a demasking at the end of the computation). The encryption algorithm can be for example AES, and a MAC algorithm can be for example AES-CMAC (AES in Cipher MAC mode) or an HMAC (Hash based MAC). The masking protection implemented by the processing device 2 (acting in this case as a protection device) can be a Boolean masking (as described for example I, Blömer, J., Guajardo, J., Krummel, V. (2004). Provably Secure Masking of AES. In: Handschuh, H., Hasan, M.A. (eds) Selected Areas in Cryptography. SAC 2004. Lecture Notes in Computer Science, vol 3357. Springer, Berlin, Heidelberg. https://doi.org/10.1007/978-3-540-30564-4_5).

In another application of the disclosure wherein the processing system is a computing system configured to execute a computer program (such as a compiler), the input $x$ to which the Boolean function $f$ is applied may be a control signal in a computer program, whose value allows to select the subsequent execution path. The decision on the onward execution of the computer program is subject to the evaluation of conditions on the control signal $x$. These conditions are expressed as Boolean functions $f$ that "decode" the value of the control signal $x$. As such control flow forks can be present in timing-critical parts of the code. To be trigger cache prediction misses, it is important that they execute efficiently. Using the Boolean function evaluation device and method according to the embodiments of disclosure to evaluate such Boolean functions that define the above conditions enables fast and constant-time, thereby not affecting the instruction cache. Alternatively, the invention can be used to "artificially" complexity a computer program, in that the way the condition is written in assembly language (with ADC operations where Boolean operators, such as XOR, AND, OR, etc. are expected) is hard to interpret hence to reverse-engineer. This provides a level of protection on the exact nature of the condition that is executed.

In still application of the disclosure wherein the processing system 1 is a solver, the input $x$ to which the Boolean function *f* is applied may be an instance of a satisfiability problem, that is an efficient algorithm to solve a binary complex combinational problem ('binary' means (in the sense that the answer is either "yes" or "no"). The solver adapted to solve this kind of problem is referred to as a SAT-solver (SAT-solver stands for 'SATisfiability solver)'. A SAT-solver consists in evaluating exhaustively solutions, a way that allows to prune inconsistant solutions though. The efficiency of a SAT-solver remains conditioned by the speed at which conditions are evaluated. The conditions of the SAT-solver are Boolean functions that can be evaluated using the Boolean function evaluation device and method according to the embodiments of disclosure. It should be noticed that satisfiability of instances of 64 bit and above are hard to solve by an exhaustive search. Iinstance of 128 bits or more simply are in particular impossible to solve in this way. A size of 128 bits corresponds to the key size of modern cryptographic algorithm, and they withstand exhaustive search even if all available computers would be used in parallel for this sole problem instance. However, a problem expressed as a 64 or 128 bits problem can be efficiently solved by a SAT-solver, which is sped up by our invention. Also, the SIMD version of our invention allows an additional speed up by using the Boolean function evaluation device and method according to the embodiments of disclosure to evaluate the Boolean functions corresponding to the conditions of the SAT-solver.

In another application of the disclosure wherein the processing system 1 is a digital processing system and the processing device 20 is a signal processing processor of the digital processing system, the input *x* to which the Boolean function *f* is applied may be a digitalized signal, which is input in the signal processing processor. The digitalized signal *x* can arrive at a very high rate and must therefore be processed fast and at a deterministic speed. Otherwise, it can happen that some data is congestioned, hence not processed as scheduled, and unfortunately dropped (leading to errors). The processing can consist in Finite Impulse Response (FIR) or Infinite Impulse Response (IIR) filters, which have an equivalent Boolean expression forming a Boolean function. This Boolean expression can be advantageously evaluated fast and in constant time, using the Boolean function evaluation device and method according to the embodiments of disclosure. Another operation on streaming digital data is the application of a "distortion correction" table using a Look Up Table (LUT). The evaluation of the LUT can also use the evaluation device and method according to the embodiments of disclosure.

Embodiments of the present disclosure can take the form of an embodiment containing software only, hardware only or both hardware and software elements.

Furthermore, the methods described herein can be implemented by computer program instructions supplied to the processor of any type of computer to produce a machine with a processor that executes the instructions to implement the functions/acts specified herein. These computer program instructions may also be stored in a computer-readable medium that can direct a computer to function in a particular manner. To that end, the computer program instructions may be loaded onto a computer to cause the performance of a series of operational steps and thereby produce a computer implemented process such that the executed instructions provide processes for implementing the functions specified herein. In particular, the methods described herein may be implemented in a computer system.

It should be noted that the functions, acts, and/or operations specified in the flow charts, sequence diagrams, and/or block diagrams may be re-ordered, processed serially, and/or processed concurrently consistent with embodiments of the disclosure. Moreover, any of the flow charts, sequence diagrams, and/or block diagrams may include more or fewer blocks than those illustrated consistent with embodiments of the disclosure.

While embodiments of the disclosure have been illustrated by a description of various examples, and while these embodiments have been described in considerable detail, it is not the intent of the applicant to restrict or in any way limit the scope of the appended claims to such detail. In particular, the invention is not limited to the exemplary applications of the disclosure and exemplary processing systems mentioned in the description, as the skilled person will readily understand.

Additional advantages and modifications will readily appear to those skilled in the art. The disclosure in its broader aspects is therefore not limited to the specific details, representative methods, and illustrative examples shown and described.

## Claims

1. A processing system (1) configured to execute one or more processing operations, the execution of said one or more processing operations involving the evaluation of at least one Boolean function, wherein the processing system comprises an evaluation device (20) configured to evaluate each Boolean function *f* defined from the n-dimensional vector space $\mathbb{F}_2^n$ over the prime field vector space $\mathbb{F}_2$, in a variable *x*, *x* being a vector of length *n* over the vector space $\mathbb{F}_2^n$, wherein the evaluation device (20) comprises:

   - a differential calculation unit (203) configured to calculate differentials $\Delta f(y) = f(y) \oplus f(y - 1)$ for each integer intermediary variable *y* ranging from 1 to $2^n - 1$;

- An accumulation unit (201) configured to sum, using the XOR operator, the product of the differential $\Delta f(y)$ and $c_n^{2^n-y}(x)$ for each value of $y$ ranging from 1 to $2^n$ - 1, according to the following XOR accumulation term:

$$\bigoplus_{y=1}^{2^n-1}\big(\Delta f(y)\big)c_n^{2^n-y}(x),$$

where $c_n^z(x)$ is the function associating $x$ to the outbound carry of arithmetic summation $x + z$ ;
- A XOR adder (204) configured to add $f(0)$ to the result of the accumulation unit (201),

wherein the output of the XOR adder provides the result of the evaluation of the Boolean function $f$.

2. The processing system of claim 1, wherein the evaluation device is implemented in the form of a hardware circuit, and wherein the evaluation device (20) comprises a sequential value generator (202) configured to generate sequential values of the intermediary variable $y$ from 1 to $2^n$ - 1.

3. The processing system of claim 2, wherein the evaluation device comprises a carry generator (204) configured to determine the arithmetic carry $c_n^{2^n-y}(x)$ that is conditioned, using an AND gate, to the fact that the differential $\Delta f(y)$ is true, for each value of the intermediary variable $y$, the input $x$ being submitted to the carry generator (204), and the output of the evaluation device being provided after $2^n$ - 1 clock cycles in the accumulation unit (201).

4. The processing system of any claim 2 and 3, wherein the accumulation unit (201) comprises two multiplexors (401, 402) and a DFF memory (403), the DFF memory (403) receiving as inputs the output of the second multiplexor and a system clock signal.

5. The processing system of any claim 2 to 4, wherein the sequential value generator (202) is implemented as a counter and comprises an adder (501), without a carry, followed by a DFF memory (502) that receives, as inputs, the output of the adder (501) and a system clock signal, the DFF memory returning the current value of the intermediary variable, the adder (501) receiving back as input the output of the DFF memory and the value 1.

6. The processing system of any claim 2 to 5, wherein the carry generator (204) comprises an adder (601), with a carry, followed by an AND component (604) receiving, as inputs, the output of the adder (601) and the differential value for the current value of the intermediary variable $y$, the adder (601) receiving, as inputs, the input $x$ and an input $2^n$ - $y$, and providing an output comprising on n bits $x$ - $y$ $mod\,2^n$ and on 1 bit a carry flag corresponding to the carry $c_n^{2^n-y}(x)$, the AND component (604) being configured to perform a AND operation between the differential value $\Delta f(y)$ and the carry $c_n^{2^n-y}(x)$ .

7. The processing system of any preceding claims, wherein the evaluation device (20) is configured to evaluate the Boolean function $f$ in $K$ input values $x_k$ with $1 \le k \le K$, using a parallel Single-Instruction-Multiple-Data implementation parallelized only on the values $x_k$.

8. The processing system of any preceding claims 1 to 6, wherein the evaluation device (20) is configured to evaluate in parallel $K$ Boolean functions $f_k$ in $K$ input values $x_k$ with $1 \le k \le K$, using a Single-Instruction-Multiple-Data architecture parallelized on the values $x_k$.

9. The processing system of any preceding claims 1 to 6, wherein the evaluation device (20) is configured to evaluate a Boolean function $f$ in $x$, when the differential $\Delta f$ of the function $f$ is sparse, using a look-up-table (LUT) $V_f$.

10. The processing system of claim 9, wherein the evaluation device (20) is configured to determine the look-up table from a truth table associated with the Boolean function.

11. The processing system of any preceding claim wherein the processing system is a cryptographic system, and a processing operation is a cryptographic operation.

**12.** The processing system of any preceding claim, wherein the carry is defined from intermediate bits of the addition of $x$ and $y$.

**13.** A processing method for executing one or more processing operations, the execution of said one or more processing operations involving the evaluation of at least one Boolean function, wherein the processing method comprises a step of evaluating each Boolean function $f$ defined from the n-dimensional vector space $\mathbb{F}_2^n$ over the prime field vector space $\mathbb{F}_2$, in a variable $x$, $x$ being a vector of length $n$ over the vector space $\mathbb{F}_2^n$, wherein the evaluation step comprises:

- calculating differentials $\Delta f(y) = f(y) \oplus f(y - 1)$ for each integer intermediary variable $y$ ranging from 1 to $2^n - 1$;

- summing, using the XOR operator, the product of the differential $\Delta f(y)$ and $c_n^{2^n-y}(x)$ for each value of $y$ ranging from 1 to $2^n - 1$, according to the following XOR accumulation term:

$$\bigoplus_{y=1}^{2^n-1}\left(\Delta f(y)\right)c_n^{2^n-y}(x),$$

where $c_n^z(x)$ is the function associating $x$ to the outbound carry of arithmetic summation $x + z$ ;
- adding $f(0)$ to the result of the summing step, which provides the result of the evaluation of the Boolean function $f$.

1  2  20

PROCESSING SYSTEM

Processing device

Bolean function Evaluation DEVICE

**FIGURE 1**

20

| Accumulation unit (201) | Sequential value generator (202) |
|---|---|
| Differential calculation unit (203) | Carry generator (204) |

## FIGURE 2

Pre-calculating the differentials $\Delta f(y)$ for each y ranging form 1 to $2^{n-1}$

300

Initializing the accumulator $a$ to $f(0)$

302

Accumulating $\Delta f(y)$ and the carry $c_n^{2^n-y}(x)$ in the accumator $a$ for each value of $y$ through XOR

304

Returning $a$

306

**FIGURE 3**

400

201

f(0)

401

c

402

y

clk

403

f(x)

**FIGURE 4**

202

n

1

n

n

D   Q

y   [counter]

clk   reset

502

501

**FIGURE 5**

204

FIGURE 6

**FIGURE 7**

**FIGURE 8**

204

$x_k \xrightarrow{n}$
[replicated $K$ times, for $1 \le k \le K$]

$2^n - y \xrightarrow{n}$
[or $\neg y + 1$]

$+$

$n + 1$

$n$ bits ← → 1 bit ← → [carry]

$x_k - y \bmod 2^n$ | flag

$\Delta_f(y) = f(y) \oplus f(y-1)$
[the "$\oplus$" is precomputed]

AND $\to c_k$

601

602

604

**FIGURE 9**

**FIGURE 10**

**FIGURE 11**

FIGURE 12

400

201

$f(0)$

$c$   $i{\neq}0$ clk

$f(x)$   [stable value after #$V_f$ clock cycles]

402   401

403

**FIGURE 13**

202

$n$

$i$

[Look-up table]

503

$n$

D   Q

$y \in \mathbb{F}_2^n$ s.t.
$\Delta_f(y) \neq 0$

$y$ [counter]

1   $n$

[LUT $V_f$]

clk   reset   [initialization at reset is 0]

501

502

**FIGURE 14**

204

FIGURE 15

700  Receiving  truth table associated with the Boolean function $f$

701  Initializing $prev$ variable to f(0)

For each value of $y$ from 1 to $2^n - 1$

704  $prev$ different from $f(y)$ ?

yes

705  setting $V$ is set to $V \cup \{y\}$ and setting $prev$ is set to $f(y)$

706  Returning $V$

**FIGURE 16**

| $x$ | $f(x)$ |
|---|---|
| $(0000)_2$ | 1 |
| $(0001)_2$ | 1 |
| $(0010)_2$ | 1 |
| $(0011)_2$ | 1 |
| $(0100)_2$ | 1 |
| $(0101)_2$ | 0 |
| $(0110)_2$ | 0 |
| $(0111)_2$ | 0 |
| $(1000)_2$ | 0 |
| $(1001)_2$ | 0 |
| $(1010)_2$ | 0 |
| $(1011)_2$ | 1 |
| $(1100)_2$ | 1 |
| $(1101)_2$ | 1 |
| $(1110)_2$ | 1 |
| $(1111)_2$ | 0 |

$\Longrightarrow$

| $i$ | $y = V_f(i)$ |
|---|---|
| $(0000)_2$ | $(0101)_2$ |
| $(0001)_2$ | $(1011)_2$ |
| $(0010)_2$ | $(1111)_2$ |

## FIGURE 17

Europäisches
Patentamt

European
Patent Office

Office européen
des brevets

# EUROPEAN SEARCH REPORT

**Application Number**

EP 24 30 5182

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ROK SOSIÄ ET AL: "The Unison algorithm", ACM TRANSACTIONS ON DESIGN AUTOMATION OF ELECTRONIC SYSTEMS, ACM, NEW YORK, NY, US, vol. 1, no. 4, 1 October 1996 (1996-10-01), pages 456-477, XP058348735, ISSN: 1084-4309, DOI: 10.1145/238997.239009 * figure 1 * * Sections 2, 3.1, 3.2 * * Equations (1)-(6) * | 1-13 | INV. G06F7/544 G06F17/10 |
| X | US 5 291 612 A (SOSIC ROK [US] ET AL) 1 March 1994 (1994-03-01) * figures 1-5 * * column 1 - column 5 * | 1-13 | |
| A | SUBHADEEP BANIK ET AL: "Compact Circuits for Efficient Mobius Transform", IACR, INTERNATIONAL ASSOCIATION FOR CRYPTOLOGIC RESEARCH , vol. 20230616:213939 16 June 2023 (2023-06-16), pages 1-31, XP061078953, Retrieved from the Internet: URL:https://eprint.iacr.org/archive/2023/948/1686951579.pdf [retrieved on 2023-06-19] * the whole document * | 1-13 | **TECHNICAL FIELDS SEARCHED (IPC)** G06F |

The present search report has been drawn up for all claims

| Place of search | Date of completion of the search | Examiner |
|---|---|---|
| Munich | 16 July 2024 | Winkelbauer, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 30 5182

This annex lists the patent family members relating to the patent documents cited in the above-mentioned European search report.
The members are as contained in the European Patent Office EDP file on
The European Patent Office is in no way liable for these particulars which are merely given for the purpose of information.

16-07-2024

| Patent document cited in search report | Publication date | Patent family member(s) | Publication date |
|---|---|---|---|
| US 5291612 A | 01-03-1994 | CA 2060727 A1 | 12-08-1992 |
| | | US 5291612 A | 01-03-1994 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Provably Secure Masking of AES. **I, BLÖMER, J.** ; **GUAJARDO, J.** ; **KRUMMEL, V.** Selected Areas in Cryptography. Springer, 2004, vol. 3357